# EUROPÄISCHE PATENTANMELDUNG

(11) **EP 4 006 948 A1**
(43) Veröffentlichungstag der Anmeldung: **01.06.2022**
(21) Anmeldenummer: 20210012.9
(22) Anmeldetag: 26.11.2020
(51) Int. Cl.: H01J 27/02, H01J 37/32

(54) **EXTRAKTIONSGITTER**

(71) Anmelder: Bühler AG, 9240 Uzwil (CH)
(72) Erfinder: REUS, Holger, 63579 Freigericht (DE); REPPIN, Daniel, 35753 Greifenstein (DE); MÜLLER, Dirk, 63543 Neuberg (DE); LIU, Simon, 63500 Seligenstadt (DE); HAGEDORN, Harro, 60435 Frankfurt (DE)
(74) Vertreter: Vossius & Partner Patentanwälte Rechtsanwälte mbB

(57) **Zusammenfassung**

Eine Vorrichtung zur Extraktion von Ionen und/oder Elektronen aus einem Plasma weist ein Gitter 1 und einen Gitterhalter 2 auf, an dessen Umfang das Gitter 1 befestigt ist. Erfindungsgemäß ist das Gitter 1 als Streckmetallgitter ausgeführt. Mit der Erfindung werden ferner eine Plasmaquelle, eine Plasmabeschichtungsvorrichtung, sowie ein Verfahren zur Herstellung einer Interferenzschicht bzw. von Interferenzschichtsystemen bereitgestellt.

## Beschreibung

Die Erfindung betrifft allgemein Plasmastrahlquellen, die beispielsweise in Vakuumbeschichtungsverfahren verwendet werden, und insbesondere eine Extraktionsvorrichtung zum Extrahieren von Ionen und/oder Elektronen aus einem Plasma.

Bei einer Vielzahl von Verfahren zur Behandlung von Oberflächen, beispielsweise Beschichten, Strukturieren oder Ätzen, wird ein Plasma eingesetzt, um Ionen bestimmter Materialien, insbesondere Gase zu erzeugen, mit deren Hilfe die Verfahren durchgeführt werden. So kann beispielsweise bei Vakuumbeschichtungsverfahren eine Plasmaquelle eingesetzt werden, aus der geladene Teilchen extrahiert werden, die dann zum Abtragen einer Oberfläche oder auch zum Aufdampfen auf eine Oberfläche verwendet werden können, beispielsweise zum Auftragen eine Oxidschicht. Das Plasma kann hierbei beispielsweise kapazitiv, also in einem elektrischen Wechselfeld, induktiv oder durch Mikrowellen erzeugt werden. Die geladenen Teilchen, also insbesondere Ionen oder Elektronen, können mit Hilfe einer Elektrode aus dem Plasma extrahiert werden.

Zur Extraktion der Ionen bzw. Elektronen aus dem Plasma ist es bekannt, ein Metallgitter bzw. Metallnetz zu verwenden.

Die EP 0 349 556 B1 beschreibt in diesem Zusammenhang eine Vorrichtung zum Abtragen von Oberflächenschichten durch Teilchenbeschuss aus einem Plasma, bei der die Flächen der Elektroden so gewählt sind, dass nahezu die gesamte Hochfrequenzspannung an der einen als feines Gitter ausgebildeten Extraktionselektrode abfällt, um einen möglichst großflächigen homogenen Beschuss von Oberflächen mit Atom- oder Molekülionenstrahlen einer hohen Parallelität zu erreichen. Diese Elektrode wird als geeignet konfiguriertes Drahtnetz in Form parallel verlaufender Drähte ausgeführt.

Weiterhin beschreibt die DE 10 2004 011 118 A1 eine Extraktionselektrode für eine Plasmastrahlquelle, wobei die Extraktionselektrode als kreisförmige Trägerplatte mit einem Lochblendenmuster ausgebildet ist

Zur Aufrechterhaltung der Homogenität des Strahls aus extrahierten Ionen und/oder Elektronen ist es wesentlich, die Form des Extraktionsgitters möglichst lange konstant zu halten, da die Form wesentlich den Strahl der extrahierten Ionen und Elektronen aus dem Plasma beeinflusst. Gerade bei den im Stand der Technik verwendeten Gittern ist die Langlebigkeit und damit die Prozessstabilität ein Problem, da durch die Wärmeausdehnung der verschiedenen Materialien und Systeme, die bei der Bestrahlung verursacht wird, die Langlebigkeit der Elektrode beeinträchtigt. Die Wärmeausdehnung sorgt insbesondere für eine mechanische Deformation des Gitters und hat somit einen sehr negativen Einfluss auf die Verteilung der Ionen/Elektronen und damit der Beschichtungseigenschaften.

Es ist daher eine Aufgabe der vorliegenden Erfindung, eine Extraktionsvorrichtung bereitzustellen, die eine gleichmäßige, langzeitstabile Verteilung der Ionen/Elektronen gewährleisten kann.

Diese Aufgabe wird mit der Extraktionsvorrichtung, der Plasmaquelle, der Plasmabeschichtungsvorrichtung bzw. dem Verfahren gemäß den angehängten Ansprüchen gelöst; die Unteransprüche beschreiben Ausführungsformen der vorliegenden Erfindung.

Die vorliegende Erfindung stellt eine Extraktionsvorrichtung zur Extraktion von Ionen und/oder Elektronen aus einem Plasma bereit. Die Vorrichtung weist ein Gitter und einen Gitterhalter auf, an dessen Umfang das Gitter befestigt ist. Erfindungsgemäß ist das Gitter als Streckmetallgitter ausgeführt. In einer Draufsicht weist die Vorrichtung vorzugsweise im Wesentlichen eine Kreisform auf.

Der Gitterhalter kann einen Grundkörper und einen Spannring aufweisen, mit dem das Streckmetallgitter am Grundkörper befestigt ist. Ferner kann zwischen dem Grundkörper und dem Spannring ein Abstandshalter angeordnet sein.

Das auf dem Gitterhalter befestigte Streckmetallgitter bildet vorzugsweise eine dreidimensional gekrümmte Oberfläche, die allgemein im Wesentlichen eine Zylinderfläche darstellt. Die Krümmungsradien können um den Scheitelpunkt symmetrisch sein. Gemäß einer Ausführungsform können sich die beiden Krümmungsradien auf den Seiten des Scheitelpunkts auch unterscheiden, so dass eine asymmetrische Form des Gitters um den Scheitelpunkt ausgebildet ist.

Gerade im Fall einer asymmetrischen Zylinderfläche kann insbesondere der Scheitelpunkt aus der Mitte des Gitters versetzt oder verkippt sein. Zusätzlich oder alternativ können sich auch die Krümmungsradien der Hauptrichtungen und/oder die Krümmungsradien innerhalb der Hauptrichtungen unterscheiden.

Als Material für das Gitter kann ein elektrisch leitfähiges Metall verwendet werden, insbesondere Metalle, deren Oxide optisch transparent und/oder ebenfalls in den abgeschiedenen Schichten Verwendung finden. Beispielhaft sind Titan, Tantal, Hafnium, Aluminium, Zirkon, Niob, deren Legierungen und Edelstahl genannt. Das Gitter kann ferner mit einem Oxid, insbesondere Aluminiumoxid, beschichtet sein, das optisch transparent ist und die Lebensdauer des Gitters deutlich erhöht, da es die Erosionsrate des Gitters durch den Plasmaionenbeschuss reduziert.

Beispielhafte Abmessungen des Gitters sind eine Dicke von 0,05 mm bis 3 mm, ein Durchmesser von etwa 10 cm bis 50 cm, insbesondere von 30 cm, eine Maschenlänge von 0,5 mm bis 10 mm, eine Maschenbreite von 0,5 mm bis 10 mm, eine Stegbreite von 0,1 mm bis 10 mm und/oder eine Stegdicke von 0,1 mm bis 10 mm.

Durch die Erfindung wird ferner eine Plasmaquelle bereitgestellt, die eine Plasmakammer, eine Gaszufuhr zum Zuführen eines Gases in die Plasmakammer, eine Vorrichtung zum Erzeugen eines Plasmas innerhalb der Plasmakammer, und die erfindungsgemäße Vorrichtung zur Extraktion von Ionen und/oder Elektronen aus dem Plasma aufweist. Der Halter der Extraktionsvorrichtung sollte die Quelle RF-Strahlungsdicht abschließen. Das Gitter soll insbesondere elektrischen Kontakt haben und gleichzeitig gleitend gelagert sein.

Die Plasmaquelle kann insbesondere in einer Beschichtungsvorrichtung, insbesondere mit Verfahren wie Elektronenstrahlverdampfen, thermisches Verdampfen, Sputtern, Plasma-Enhanced-Chemical-Vapor-Deposition, Verwendung finden, wobei gegenüber der Plasmaquelle ein Substrathalter zum Halten der zu beschichteten Substrate angeordnet ist. Der Substrathalter weist bevorzugt eine in Bezug auf die Plasmaquelle im Wesentlichen konkav gekrümmte oder aber auch planare Oberfläche auf. Der Substrathalter kann ferner eine Planetenanordnung mit planer oder konkav gekrümmter Oberfläche aufweisen, wobei an der Oberfläche ein oder mehrere zu beschichtende Substrate angeordnet sind.

Dabei ist das Gitter der Vorrichtung zur Extraktion vorzugsweise derart geformt, dass die Plasmaverteilung auf der Oberfläche des Substrathalters im Wesentlichen gleichförmig ist. Der Substrathalter kann etwa 50 cm bis 200 cm, vorzugsweise 80 cm entfernt von der Plasmaquelle angeordnet sein. Der Krümmungsradius des Substrathalters kann von etwa 80 cm bis 150 cm, vorzugsweise 130 cm betragen.

Durch die Erfindung wird ferner ein Verfahren zur Herstellung einer Interferenzschicht bzw. von Interferenzschichtsystemen, insbesondere unter der Verwendung der erfindungsgemäßen Vorrichtung zur Extraktion von Ionen und/oder Elektronen aus einem Plasma bereitgestellt. Das Verfahren erlaubt die Herstellung von Schichten mit sehr homogener Verteilung der Schichteigenschaften über den gesamten Substrathalter, wobei die Abweichung der Plasmaverteilung, gemessen zum Beispiel als Ätzrate von SiO₂, vom Mittelwert höchstens 10% beträgt.

Im Folgenden wird die Erfindung anhand der Figuren näher beschrieben.
Figur 1 zeigt eine Fotografie der Vorrichtung gemäß einer Ausführungsform der Erfindung mit Gitterhalter und daran angebrachten Streckmetallgitter.
Figur 2a zeigt eine technische Zeichnung des Gitterhalters gemäß einer Ausführungsform der Erfindung.
Figur 2b zeigt schematisch die Krümmungsvarianten des Gitters.
Figur 3 zeigt ein Diagramm der Ätzrate über die Position für eine Extraktionselektrode des Stands der Technik mit einem Gitternetz.
Figur 4 zeigt die Verteilung der Ätztrate für eine Vorrichtung gemäß einer Ausführungsform der Erfindung auf einer Kalotte mit dem Krümmungsradius 107 cm.
Figur 5a zeigt den Vergleich der Ätzrate über die Position für die Extraktionselektrode des Standes der Technik mit einem Gitternetz zu der Ätzrate für eine Vorrichtung gemäß einer Ausführungsform der Erfindung auf einer Kalotte mit Krümmungsradius 130 cm.
Figur 5b zeigt die Verteilung des Brechungsindex von TiO2 der auf der Kalotte mit der hier beschriebenen Erfindung erreicht werden kann.
Figur 6 zeigt die mit der Vorrichtung gemäß der Ausführungsform der Erfindung erzielten spektralen Kurven einer TiO₂ Einzelschicht auf Substraten, die entlang des Kalottenradius positioniert waren und der gewünschten, gleichmäßigen Verteilung entsprechen.
Figur 7 zeigt die mit der Vorrichtung gemäß der Ausführungsform der Erfindung erzielten spektralen Kurven eines Interferenzschichtsystems auf Substraten, die entlang des Kalottenradius positioniert waren und der gewünschten, gleichmäßigen Verteilung entsprechen.
Figur 8 zeigt ein Beispiel einer unerwünschten Verteilung anhand einer TiO₂ Einzelschicht, wie sie mit dem Netzhalter des Standes der Technik erzielt wird.

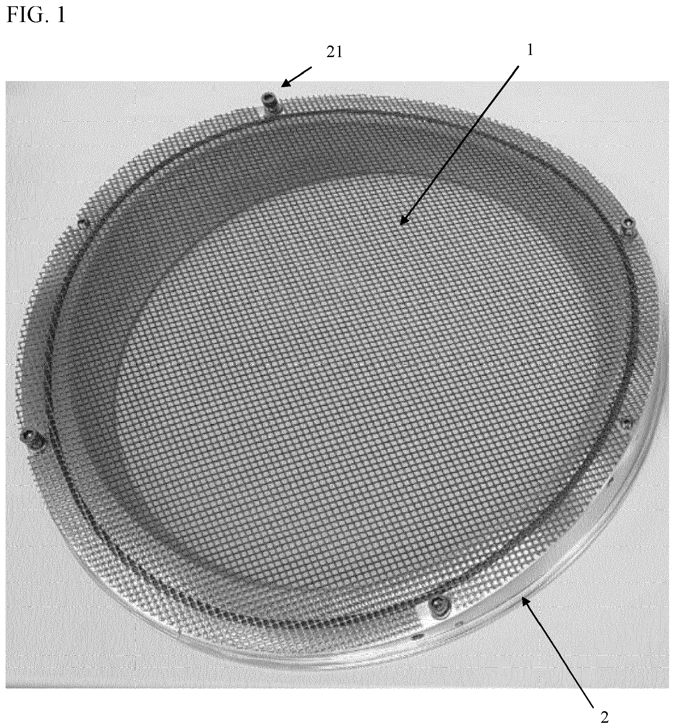

Die Extraktionsvorrichtung, wie sie in der Figur 1 gezeigt ist, weist einen Gitterhalter 2 auf, der im Wesentlichen die Form der Extraktionsvorrichtung vorgibt. Auf dem Gitterhalter 2 ist ein rundes bzw. ovales Gitter 1 befestigt. Insbesondere ist der Gitterhalter 2 derart geformt, dass das darauf befestigte Gitter 1 in der Draufsicht eine Kreisform aufweist und eine dreidimensional gekrümmte Oberfläche bildet, die bevorzugt im Wesentlichen eine Zylinderfläche darstellt. Um den Scheitelpunkt kann die Zylinderfläche symmetrisch gekrümmt sein. Es kann aber auch vorteilhaft sein, dass die Zylinderfläche um den Scheitelpunkt unterschiedliche Krümmungsradien aufweist, also asymmetrisch gekrümmt ist. In der in Figur 1 dargestellten Ausführungsform ist das Gitter 1, das als Streckmetallgitter ausgeführt ist, mit vier Schrauben 21 am Gitterhalter befestigt. Gemäß einer Ausführungsform kann der Gitterhalter einen Grundkörper und einen Spannring (in Fig. 1 nicht gezeigt) aufweisen. Gegebenenfalls kann zwischen dem Grundkörper und dem Spannring ein Abstandshalter angeordnet sein. Durch den Abstandshalter wird sichergestellt, dass das Streckmetall gleitend auf der RF-Dichtung des Grundkörpers aufliegt und die Wärmeausdehnung kompensiert werden kann ohne, dass die Form des Gitters und damit die Plasmaverteilung durch Deformation verändert wird.

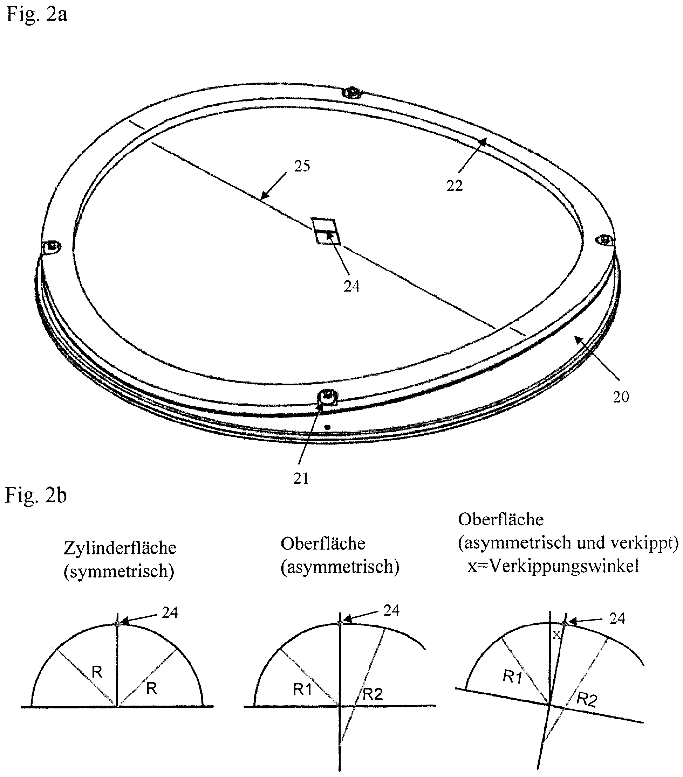

Der Gitterhalter ist in Figur 2a nochmals schematisch gezeigt. Hier sind der Grundkörper 20, die Schrauben 21 und der Spannring 22 gezeigt. Die Form des Gitterhalters 2 ist derart, dass ein darauf angeordnetes Gitter um die Scheitellinie 25 gekrümmt ist, und so im Wesentlichen eine Zylinderfläche bildet. Diese Scheitellinie 25 und damit der Scheitelpunkt 24 können mittig in dem einen Ring bildenden Gitterhalter, oder auch aus der Mitte versetzt bzw. verkippt sein. Die Krümmungsradien seitlich des Scheitelpunkts 24 können gleich oder auch unterschiedlich ausgebildet sein, wie in der Figur 2b dargestellt. Hier sind eine symmetrische Anordnung, eine asymmetrische Anordnung mit unterschiedlichen Krümmungsradien rechts und links des Scheitelpunkts 24 und eine asymmetrische und zusätzlich verkippte Anordnung, in der der Scheitelpunkt 24 aus der Mitte versetzt angeordnet ist, schematisch gezeigt.

Durch einen gegebenenfalls zwischen Grundkörper 20 und Spannring 22 vorgesehenen Abstandshalter kann verhindert werden, dass das Gitter auf dem Grundkörper 20 fest angezogen werden kann. So ist es dem Gitter möglich, sich zwischen dem Grundkörper 20 und Spannring 22 flächig auszudehnen, ohne dass eine Plasmaverteilung nachteilig beeinflusst wird.

Durch das Ausbilden des Gitters in Form eines Streckmetallgitters wird eine gleichmäßige, langzeitstabile Verteilung der Ionen auf einen gegenüber der Plasmaquelle angeordneten Substrathalter gewährleistet. In der Regel sind die Substrate gegenüber der Plasmaquelle auf einem Substrathalter, beispielsweise in Form einer Kalotte angeordnet, die in Bezug auf die Plasmaquelle konkav gekrümmt ist. Der Substrathalter kann auch eine planare Form haben. Die Krümmung des Gitters muss für eine optimale Verteilung an die Form der als Substrathalter fungierenden Kalotte angepasst werden.

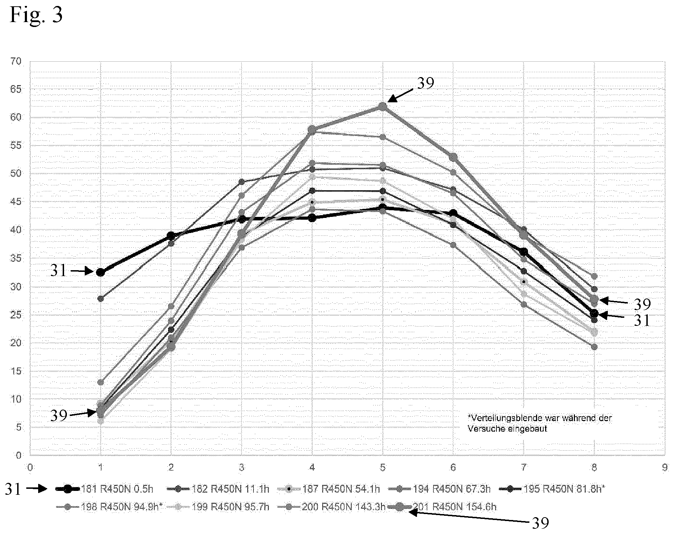

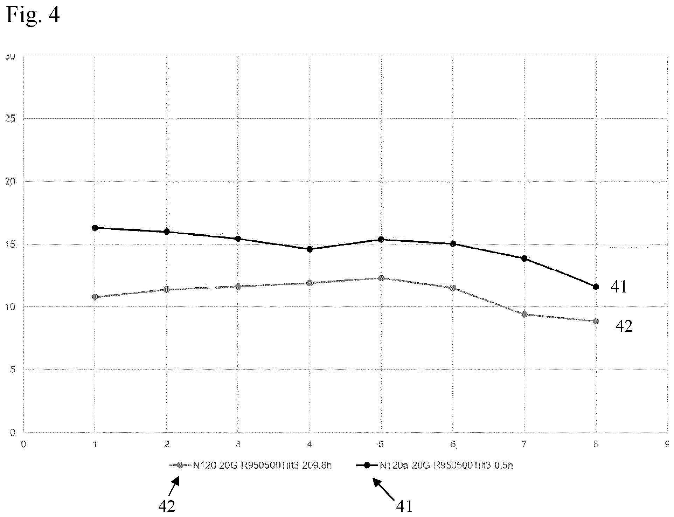

Die Anpassung des Gitters an die verwendete Kalotte spiegelt sich in Diagrammen wider, die beispielsweise eine Ätzrate von SiO₂ über die Fläche der Kalotte zeigen, wie in Figuren 3 und 4 dargestellt. Eine optimale, also homogene Verteilung des Ionenstroms würde sich in diesen Diagrammen als eine horizontale Linie über die gesamte Ausdehnung der Kalotte darstellen.

Die Figur 3 zeigt die Ätzrate über die Ausdehnung der Kalotte (Krümmungsradius 107 cm) für unterschiedliche Einsatzdauern, angegeben als Betriebsstunden, bei Verwendung eines bisher bekannten Netzes, also eines Drahtgitters gemäß dem Stand der Technik. Während die Verteilung zu Beginn (Bezugsziffer 31, nach einer halbes Stunde Betriebsdauer) noch akzeptabel erscheint, ändert sich die Verteilung bereits nach wenigen Stunden drastisch und ist nach einer Betriebsdauer von 154,6 Stunden (Bezugsziffer 39) erheblich verschlechtert. Insbesondere ist die Ätzrate in der Mitte der Kalotte um einen Faktor 3 bis 10 höher als an den Rändern der Kalotte, was zu einer ungleichmäßigen Verteilung auf dem Substrat in Abhängigkeit ihrer Anordnung auf der Kalotte führen würde.

Zum Vergleich zeigt die Figur 4 die Lebensdauer eines Gitterhalters gemäß einer Ausführungsform der vorliegenden Erfindung. Hier zeigt sich, dass die Verteilungen zu Beginn (Bezugsziffer 41, nach einer halben Stunde Betriebsdauer) und nach ca. 210 Stunden (Bezugsziffer 42) sehr ähnlich sind. Insbesondere ist die Verteilung über die Ausdehnung der Kalotte (Krümmungsradius 107 cm) weitgehend homogen, lediglich die absoluten Ätzraten sind nicht identisch, was durch den unterschiedlichen Reinigungszustand der Anlage erklärt werden kann.

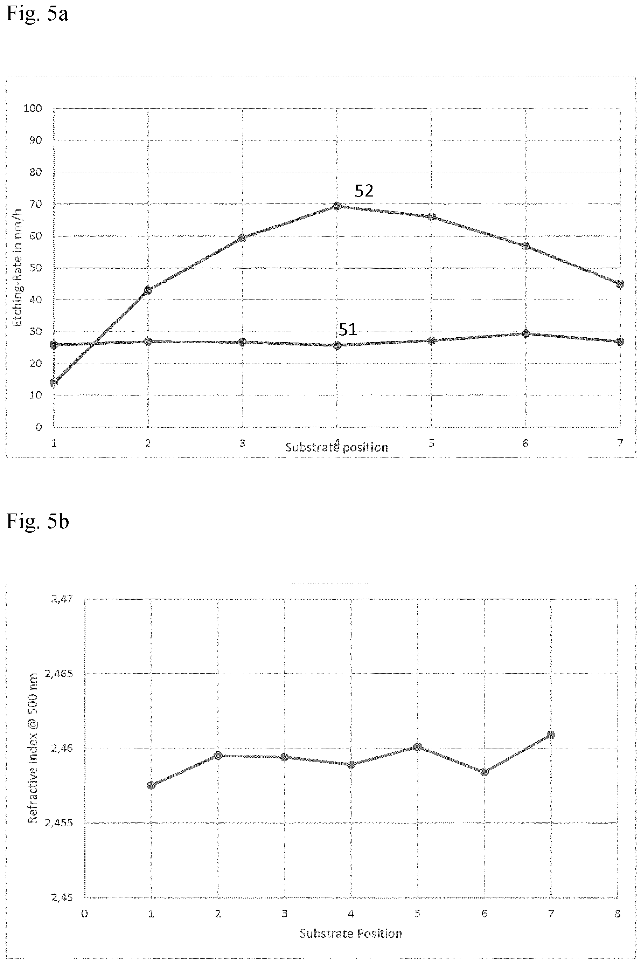

Die Figur 5 zeigt die Verteilung der Ätzrate über der Position eines Substrathalters mit einem Krümmungsradius von 130 cm, also einer geringeren Krümmung als die in den Figuren 3 und 4 verwendeten Kalotte. Hier zeigt sich eine noch bessere Verteilung mit dem hier dargestellten Gitterhalter mit Streckmetallnetz gemäß der Erfindung (Bezugsziffer 51) gegenüber der Verwendung eines herkömmlichen Gitterhalters (Bezugsziffer 52). Aus der in Figur 5a gezeigten Ätzrate unter Verwendung des Gitterhalters mit Streckmetallnetz ergibt sich die in Figur 5b gezeigte Verteilung des Brechungsindex bei 500 nm über die Position auf der Kalotte. Die in Figur gezeigte Ätzrate beträgt im Mittel 26,9 nm/h mit einem Minimum von 25,6 nm/h (Abweichung -4,6%) und einem Maximum von 29,3 nm/h (Abweichung +9,2%). Allgemein liegt die Verteilung der Ätzrate in einem Bereich von ± 10%. Damit kann die in der Figur 5b gezeigte Verteilung des Brechungsindex für TiO₂ mit einem Mittewert von 2,4592, einem Minimum von 2,4575 und einem Maximum von 2,4609, also einer Abweichung von etwa + 0,1% erreicht werden.

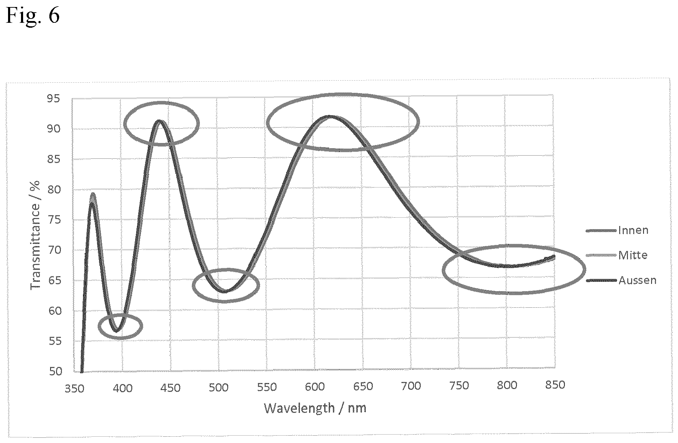

In Figur 6 ist beispielhaft die Verteilung über die Kalotte mit Krümmungsradius 130 cm für eine einzelne Interferenzschicht aus TiO₂ auf einem Glassubstrat gezeigt. Hier zeigt sich, dass die spektralen Kurven für Substratpositionen entlang des Kalottenradius nahezu aufeinander liegen, also eine sehr gute, gleichmäßige Verteilung erreicht werden kann. Dabei gibt die Übereinstimmung der Transmissionswerte der Minima und Maxima die gute Brechungsindexverteilung wieder.

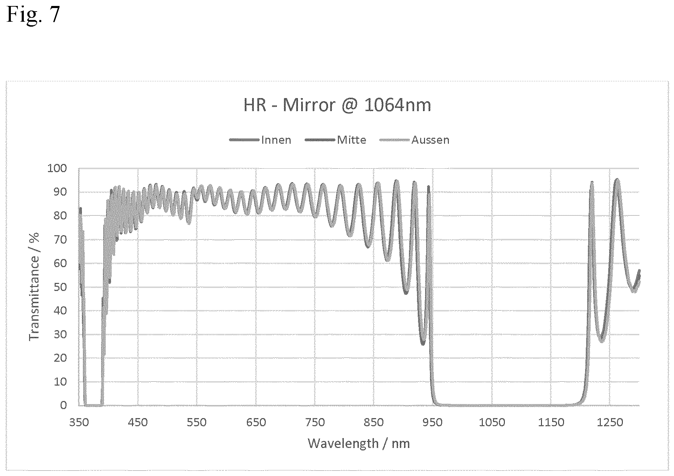

Figur 7 zeigt die Verteilung eines Interferenzschichtsystems aus TiO₂ und SiO₂ über die Kalotte mit 130 cm Krümmungsradius. Hier kann ebenfalls die sehr gute Verteilung durch das Aufeinanderliegen der Kurven dargestellt werden.

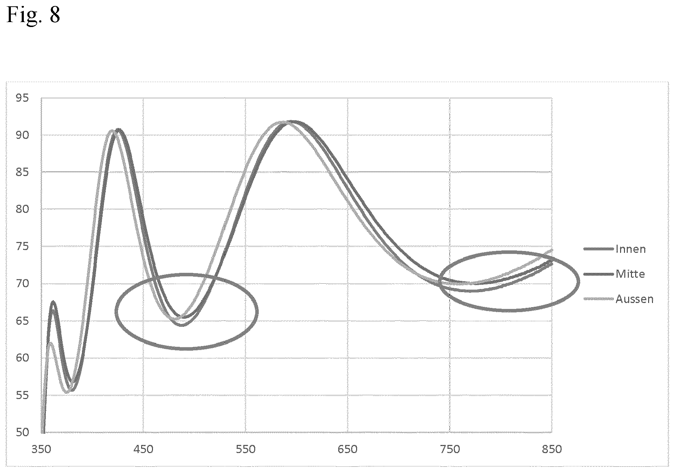

Figur 8 zeigt das Beispiel einer schlechten Brechungsindexverteilung. Die Transmissionswerte der Minima sind sehr unterschiedlich. Dieser Unterschied kann auf eine schlechte Plasmaverteilung auf der Kalotte zurückgeführt werden, wie sie sich aus der Verwendung von einem Drahtgitterhalter/Netzhalter des Stands der Technik ergibt.

Mit dem Gitter gemäß einer Ausführungsform der vorliegenden Erfindung kann also eine gleichmäßige Verteilung der extrahierten Ionen/Elektronen in einer Plasma-gestützten Behandlungsanlage, beispielsweise einer Beschichtungsanlage erreicht werden. Die gleichmäßige Verteilung bleibt über mehr als 200 Stunden Betriebsdauer erhalten, wohingegen die Verteilung bei Verwendung eines Netzhalters gemäß dem Stand der Technik nicht konstant bleibt (siehe Figur 3).

Diese Langlebigkeit ist zum einen der Halterkonstruktion geschuldet, die es dem Streckmetallgitter erlaubt, sich gleichmäßig auszudehnen. Dem gegenüber verlieren die Drähte, die in dem Extraktionsgitter des Stands der Technik verwendet werden, durch Wärmeausdehnung an Spannung und können die zu Beginn ausgebildete Sattelform nicht gleichmäßig beibehalten. Dadurch kommt es zu einem gravierenden negativen Einfluss auf die erhaltenen Schichteigenschaften, insbesondere auf den äußeren Positionen der Kalotte, wo sich aufgrund der konkav gekrümmten Form, die meisten Substrate befinden. Die Formstabilität des Gitterhalters gemäß der vorliegenden Erfindung wird dadurch erreicht, dass der Gitterhalter so konzipiert ist, dass sich das darauf befestigte Gitter ausdehnen kann, aber seine Form behält und sich nicht unkontrolliert deformiert. Die Form, also der Krümmungsradius des Gitters, ist hier für eine optimale Verteilung des Plasmas angepasst. Die gleichmäßige Verteilung ist durch die Form des gemäß der Erfindung verwendeten Gitterhalters beinflussbar. Diese Form, und dadurch die Plasmaverteilung, bleibt somit über viele Betriebsstunden gleich, wobei gleichzeitig der Einschluss der RF-Strahlung sichergestellt wird. Die Vorrichtung schließt die Quelle also RF-Strahlungsdicht ab.

Zum anderen stellt die Verwendung eines Streckmetalls für das Gitter einen wesentlichen Faktor für die Formstabilität dar. Ein Streckmetall wird durch Strecken eines mit im Allgemeinen versetzt angeordneten Schnitten versehenen Metallblechs hergestellt. Für das Streckmetall wird bei Verwendung in der vorliegenden Erfindung bevorzugt ein elektrisch leitfähiges Metall verwendet, insbesondere Titan, Tantal, Hafnium, Aluminium, Zirkon, Niob, deren Legierungen und Edelstahl. Das Gitter kann weiterhin mit einem Oxid, insbesondere Aluminiumoxid, beschichtet sein. In diesem Fall muss aber der Rand des Gitters frei von Beschichtung sein, um die elektrische Kontaktierung sicher zu stellen.

Das so entstandene Streckmetallgitter bietet elektrische Leitfähigkeit und Formstabilität, ebenso wie eine gleichmäßige Wärmeausdehnung, die durch den Halter geführt wird. Ebenso minimiert die Form des Streckmetalls die Auflagefläche auf den Halter und damit den Wärmeabfluss zum Halter. Der Temperaturgradient über das Gitter wird so minimiert.

Eine solche Extraktionsvorrichtung wird insbesondere in einer Plasmaquelle verwendet, die bekanntermaßen eine Plasmakammer aufweist, in der das Plasma insbesondere durch Anlegen einer RF-Spannung erzeugt wird, eine Gaszufuhr zum Zuführen des Gases in die Plasmakammer und der Extraktionsvorrichtung gemäß der vorliegenden Erfindung. Durch Anlegen einer Spannung an dem Gitter der Extraktionsvorrichtung werden die geladenen Ionen bzw. Elektronen aus dem Plasma extrahiert und in Richtung der gegenüber der Plasmaquelle angeordneten Substrate auf dem Substrathalter beschleunigt.

Zur Herstellung der erfindungsgemäßen Extraktionsvorrichtung wird ein Streckmetallgitter bereitgestellt und dieses auf einem Gitterhalter geeignet befestigt. Die Form des Gitterhalters bestimmt hierbei die Form des bevorzugt wie oben beschrieben gekrümmten Gitters.

Die Extraktionsvorrichtung und damit die Plasmaquelle der vorliegenden Erfindung kann bei der Beschichtung von Substraten und insbesondere bei der Herstellung einer Interferenzschicht bzw. Interferenzschichtsystemen eingesetzt werden. Für die Herstellung der Interferenzschichten bzw. Interferenzschichtsysteme ist eine homogene Verteilung der Brechungsindices der aufgebrachten Materialien über den Substrathalter von Vorteil. Für diese homogene Verteilung wird ein gleichmäßiger Plasmastrahl über den Substrathalter benötigt, dieser wird durch die vorliegende Erfindung bereitgestellt.

## Patentansprüche

1. Vorrichtung zur Extraktion von Ionen und/oder Elektronen aus einem Plasma, mit einem Gitter (1), und
einem Gitterhalter (2), an dem das Gitter (1) an seinem Umfang befestigt ist,
wobei das Gitter (1) als Streckmetallgitter ausgeführt ist.

2. Vorrichtung nach Anspruch 1, wobei die Vorrichtung in Draufsicht im Wesentlichen eine Kreisform aufweist.

3. Vorrichtung nach Anspruch 2, wobei der Gitterhalter (2) einen Grundkörper (20) und einen Spannring (22) aufweist, mit dem das Streckmetallgitter (1) am Grundkörper (20) befestigt ist.

4. Vorrichtung nach Anspruch 3, wobei zwischen Grundkörper (20) und Spannring (22) ein Abstandshalter angeordnet ist, wobei durch den Abstandshalter das Streckmetallgitter (1) bevorzugt gleitend auf einer RF-Dichtung des Grundkörpers (20) aufliegt.

5. Vorrichtung nach einem der vorstehenden Ansprüche, wobei das auf dem Gitterhalter (2) befestigte Streckmetallgitter (1) eine dreidimensional gekrümmte Oberfläche bildet, die im Wesentlichen eine Zylinderfläche darstellt, die unterschiedliche Krümmungsradien, symmetrisch wie asymmetrisch um den Scheitelpunkt (24) haben kann.

6. Vorrichtung nach Anspruch 5, wobei die Zylinderfläche asymmetrisch ist, wobei insbesondere der Scheitelpunkt (24) aus der Mitte des Gitters versetzt/verkippt ist und/oder sich die Krümmungsradien der Hauptrichtungen und/oder die Krümmungsradien innerhalb der Hauptrichtungen unterscheiden.

7. Vorrichtung nach einem der vorstehenden Ansprüche, wobei das Gitter (1) ein elektrisch leitfähiges Metall, insbesondere Titan, Tantal, Hafnium, Aluminium, Zirkon, Niob, deren Legierungen und Edelstahl aufweist.

8. Vorrichtung nach einem der vorstehenden Ansprüche, wobei das Gitter (1) mit einem Oxid, insbesondere Aluminiumoxid, belegt ist.

9. Vorrichtung nach einem der vorstehenden Ansprüche, wobei das Gitter (1) eine Dicke von 0,05 mm bis 3 mm, einen Durchmesser von etwa 10 bis 50 cm, insbesondere von 30 cm, eine Maschenlänge von 0,5 mm bis 10 mm, eine Maschenbreite von 0,5 mm bis 10 mm, eine Stegbreite von 0,1 mm bis 10 mm und/oder eine Stegdicke von 0,1 mm bis 10 mm aufweist.

10. Plasmaquelle mit
einer Plasmakammer,
einer Gaszufuhr zum Zuführen eines Gases in die Plasmakammer,
einer Vorrichtung zum Erzeugen eines Plasmas innerhalb der Plasmakammer, und
der Vorrichtung zur Extraktion von Ionen und/oder Elektronen aus dem Plasma nach einem der vorstehenden Ansprüche,
wobei der Gitterhalter (2) der Extraktionsvorrichtung die Plasmakammer vorzugsweise RF-Strahlungsdicht abschließt und/oder das Gitter (1) gleitend gelagert ist.

11. Beschichtungsvorrichtung mit
einer Plasmaquelle nach Anspruch 10 und
einem gegenüber der Plasmaquelle angeordneten Substrathalter zum Halten der zu beschichteten Substrate.

12. Beschichtungsvorrichtung nach Anspruch 11, wobei der Substrathalter eine in Bezug auf die Plasmaquelle im Wesentlichen eine konkav gekrümmte oder planare Oberfläche oder Planetenanordnung mit planer oder konkav gekrümmter Oberfläche aufweist, wobei an der Oberfläche ein oder mehrere zu beschichtende Substrate angeordnet sind.

13. Beschichtungsvorrichtung nach Anspruch 12, wobei das Gitter der Vorrichtung zur Extraktion derart geformt ist, dass die Plasmaverteilung auf der Oberfläche des Substrathalters im Wesentlichen gleichförmig ist.

14. Beschichtungsvorrichtung nach Anspruch 12 oder 13, wobei der Substrathalter etwa 50 bis 200 cm, vorzugsweise 80 cm entfernt von der Plasmaquelle angeordnet ist und/oder einen Krümmungsradius von etwa 80 bis 150 cm, vorzugsweise 130 cm aufweist.

15. Verfahren zur Herstellung einer Interferenzschicht bzw. Interferenzschichtsystemen unter der Verwendung einer Vorrichtung zur Extraktion von Ionen und/oder Elektronen aus einem Plasma, insbesondere einer Vorrichtung nach der Ansprüche 1 bis 9, einer Plasmaquelle nach Anspruch 10 oder einer Beschichtungsvorrichtung nach einem der Ansprüche 11 bis 14, durch ein Beschichtungsverfahren, beispielsweise Elektronenstrahlverdampfen, thermisches Verdampfen, Sputtern oder Plasma-Enhanced-Chemical-Vapor-Deposition, wobei die aufgetragene Schicht eine homogene Verteilung aufweist, wobei die Abweichung der Plasmaverteilung, zum Beispiel gemessen als Ätzrate von SiO2, vom Mittelwert höchstens 10% beträgt.
